# EUROPEAN PATENT SPECIFICATION

(11) **EP 1 351 332 B1**
(45) Date of publication and mention of the grant of the patent: **25.10.2006**
(21) Application number: 02027706.7
(22) Date of filing: 10.12.2002
(51) Int. Cl.: H01Q 1/24, H01Q 9/04, H01Q 1/08

(54) **Shield case or planar antenna on pcb**
Leiterplatte mit Abschirmgehäuse oder Planarantenne
Boîtier de protection ou antenne plane sur un circuit imprimé

(30) Priority: 11.12.2001 JP 2001376721; 11.12.2001 JP 2001376838; 17.01.2002 JP 2002008620
(43) Date of publication of application: 08.10.2003
(73) Proprietor: NGK INSULATORS, LTD., Nagoya City, Aichi Pref. (JP)
(72) Inventor: Muramatsu, Naokuni, c/o NGK Insulators, Ltd., Nagoya City, Aichi Pref. (JP); Suzuki, Kenji, c/o NGK Insulators,Ltd., Nagoya City, Aichi Pref. (JP); Tsuruoka, Tatsuya, c/o NGK Insulators, Ltd., Nagoya City, Aichi Pref. (JP); Kamino, Susumu, c/o NGK Insulators, Ltd., Nagoya City, Aichi Pref. (JP)
(74) Representative: TBK-Patent

(56) References cited:
- EP-A- 0 851 531
- EP-A- 1 137 099
- WO-A-00/74171
- DE-A1- 19 842 028
- US-A- 4 111 518
- US-A- 5 831 578
- "MODULE CONNECTION" IBM TECHNICAL DISCLOSURE BULLETIN, IBM CORP. NEW YORK, US, vol. 37, no. 1, 1994, pages 595-596, XP000428895 ISSN: 0018-8689

## Description

The present invention relates to a setting construction of a shield case on the circuit board.

In a mobile wireless communication device such as for example cellular phone, a planar antenna is assembled except for a whip antenna arranged extendable with respect to a device body. The planar antenna mentioned above is mechanically fixed to the circuit board and is electrically connected to a predetermined circuit pattern arranged on the circuit board. Various connection structures between the planar antenna and the circuit board have been proposed. For example, in JP-9-284023 (JP-A-284023), the connection structure between the planar antenna, which is so-called as an inverted F antenna and the circuit board, is disclosed.

Fig. 1 shows the connection structure between the planar antenna and the circuit board described in JP-A-9-284023. A planar antenna element 1 formed by performing a punching process and a clinching process for a metal plate, which functions for example as a radiation element, a power supply strip 2a and a short circuit strip 3a formed by bending a narrow strip extended from one side end of the planar antenna element 1 in a substantially vertical direction, and a power supply terminal 2b and a short circuit terminal 3b extended in parallel with respect to the planar antenna element, which are arranged at tip portions of these power supply strip and short circuit strip, are integrally formed.

Such a planar antenna element is arranged on a circuit board 4 on which a predetermined circuit pattern is formed and electric parts are assembled. A resonance frequency of the planar antenna is determined by a size of the planar antenna element 1 in both long side direction and short side direction, and a size and a relative dielectric constant between the planar antenna element 1 and the circuit board 4. Therefore, a spacer 5 made of electrically insulated resin is inserted between the planar antenna element 1 and the circuit board 4 so as to maintain an interval between the planar antenna element and the circuit board at a constant length, thereby obtaining a stable resonance frequency.

The power supply terminal 2b and the short circuit terminal 3b are brazed respectively to a power supply pad 6 and a short circuit pad 7, which are formed on a surface of the circuit board 4. In this manner, the planar antenna is mechanically connected to the circuit board 4, and the power supply strip 2a and the short circuit strip 2b of the planar antenna are electrically connected to predetermined power supply circuit and short circuit formed on the circuit board respectively.

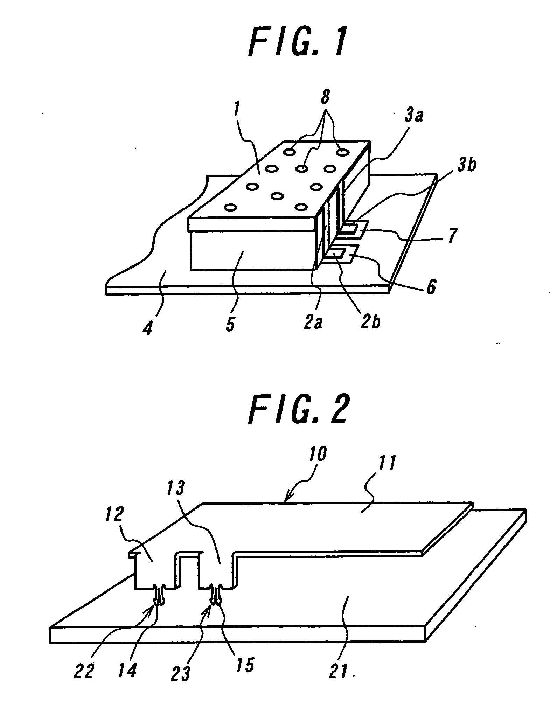

A rib is formed by bending downward both side ends of the planar antenna element 1 along a longitudinal direction so as to improve a mechanical stiffness. However, in order to further suppress a variation of interval between the planar antenna element 1 and the circuit board 4, a plurality of holes are formed on an overall surface of the planar antenna element 1, and a plurality of projections 8 positioned corresponding to those of the holes are formed on a surface of the spacer 5 at a planar antenna element side. Then, when the planar antenna and the circuit board 4 are to be assembled, they are fixed with each other by hot pressing after inserting the projections 8 into the holes. Moreover, it is not shown in Fig. 1, but a hook construction as a positioning guide is prepared on a contact surface of the spacer 5 at a circuit board side. When the planar antenna and the circuit board are to be assembled, a mechanical fitting means between a guide of the planar antenna and the circuit board is added, and the positioning is performed. Further, in order to further assure a fixing of the spacer 5, it is proposed that the spacer is fixed by means of screws to a housing of the wireless device.

The known connection structure between the planar antenna and the circuit board has the following problems.

At first, since, the power supply terminal 2b and the short circuit terminal 3b of the planar antenna element 1, and, the power supply pad 6 and the short circuit pad 7 of the circuit board 4, are fixed by brazing, the following problems arise. Since the circuit board 4 and electric parts arranged on the periphery thereof are heated by a heat generated when brazing, it is feared that they are deformed or fractured. Moreover, since a brazing flux and a brazing itself are scattered, it is feared that they are adhered to the circuit board 4 and the electric parts arranged on the periphery thereof. Further, since a washing operation, which is necessary before and after the brazing operation, is complicated, there arises an increase of manufacturing cost.

In the case that it is necessary to exchange the planar antenna for some reasons, it is necessary to break the connection by brazing. However, such an operation is extraordinarily troublesome and takes much cost. In the same manner, in the case that the communication device that expires a durable period is disposed, the planar antenna can be recycled in the greater number of cases. However, when the planar antenna is to be detached from the circuit board 4, it is necessary to remove the brazing. Such a removing operation is complicated, and thus there arises a problem such that a recycling cost is increased.

Secondly, there are following problems regarding the connection between the planar antenna and the spacer 5 made of resin or the device housing made of resin. When the projections 8 formed on a surface of the spacer 5 are inserted into the holes formed to the planar antenna element 1 and the hot pressing is performed, a partial deformation due to a heating of the planar antenna element or a plastic deformation due to an external load occurs. Therefore, it is feared that a resonance frequency is varied. Particularly, a thickness of metal plate of the planar antenna is thin for example as 0.15 mm, and thus it is easily affected by the hot pressing. Further, the cellular phone requires strongly small size, lightweight and low cost, and thus it is required to make a thickness of the planar antenna thinner. However, there arises a problem such that these requirements cannot be achieved due to the affection of the hot pressing. The same problem arises when the planar antenna and the resin housing are connected by the hot pressing. Moreover, as described on for example "New antenna engineering, (Hiroyuki Arai, April 9, 1996, sougoudenshi publisher), page 114", the planar antenna has a complicated shape such that slits or slots are formed therein so as to make it small in numerous cases. Therefore, the number of connection points by the hot pressing necessarily increases, and thus the operation becomes more complicated.

Further, when the planar antenna is subjected to the disassembling operation or the disposing operation as mentioned above, it is necessary to disassemble the planar antenna from the spacer 5 or the housing. However, an operation for breaking the portion formed by the hot pressing is complicated and requires much cost.

As a method for fixing the planar antenna to the resin spacer 5 or the resin housing, the use of adhesives and adhesive tapes may be considered other than the hot pressing. However, they are difficult for automating, and thus it is disadvantageous from the viewpoint of high efficiency and low cost of the assembling operation.

In order to overcome or reduce the problems mentioned above, it is proposed that the power supply terminal 2b and the short circuit terminal 3b of the planar antenna are connected to the circuit board 4 not by brazing but by pressing only so as to achieve the electric connection between them. In this case, since a contacting pressure between the power supply terminal 2b and the short circuit terminal 3b of the planar antenna and the power supply pad 6 and the short circuit pad 7 of the circuit board 4 is largely affected for antenna characteristics, the positions or sizes of the spacer 5 and the housing must be controlled in an extraordinarily severe manner so as to maintain a stable contacting pressure. Further, in order to achieve such a stable contacting pressure by a secure fixing, the number of the connection portions by the hot pressing between the planar antenna and the spacer or the housing must be increased considerably. In this case, the problems due to the hot pressing mentioned above are not overcome but further increased.

Moreover, in the case that the power supply terminal 2b and the short circuit terminal 3b of the planar antenna are to be connected to the circuit board 4 by pressing so as to achieve the electric connection between them, theses terminals are easily deformed. Therefore, when the planar antenna is assembled in the wireless device or when the planar antenna is strongly grasped or dropped, there is a problem such that the planar antenna is easily deformed or fractured.

In the construction such that the planar antenna is installed in the small wireless device such as cellular phone, there is a large possibility such that the planar antenna is contacted to the other electric parts or the surrounding members. In this case, it is a matter of course that the antenna characteristics are largely varied when the planar antenna is contacted to conductive members. However, even when the planar antenna is contacted to insulation members, the antenna characteristics are varied due to the deformation of the planar antenna. Therefore, when the spacer or the housing is designed or when the electric parts are assembled near the planar antenna, it is necessary not to contact them to the planar antenna. Therefore, there is a problem such that the design is restricted and troublesome.

Further, in the case that a member such as an oscillator for generating electromagnetic waves is arranged on the circuit board, in order to prevent an affection of the electromagnetic waves for the other circuit parts specifically a generation of radiation noise, it is proposed as prior arts that the electric parts are enclosed by a shield case made of a conductive metal and the electromagnetic waves are shielded so as not to propagate outward.

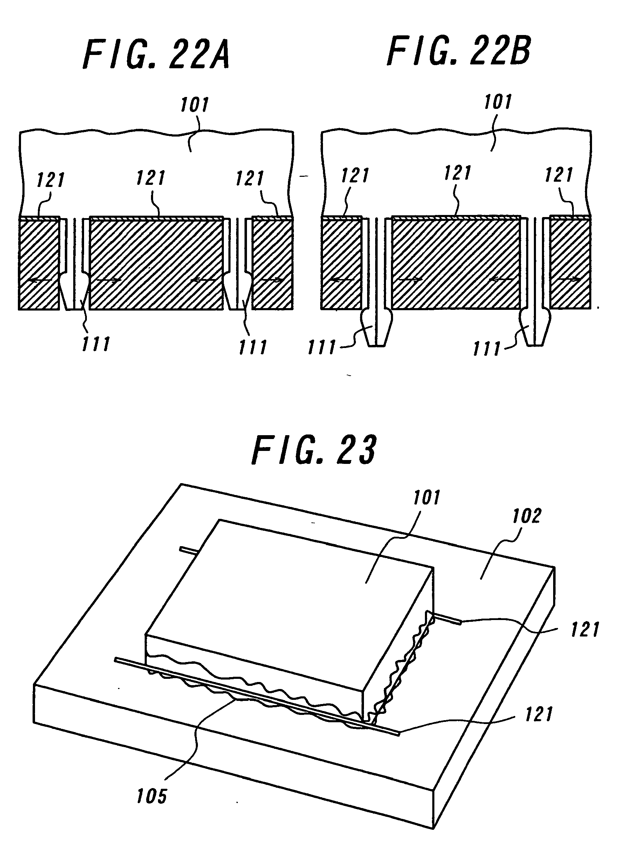

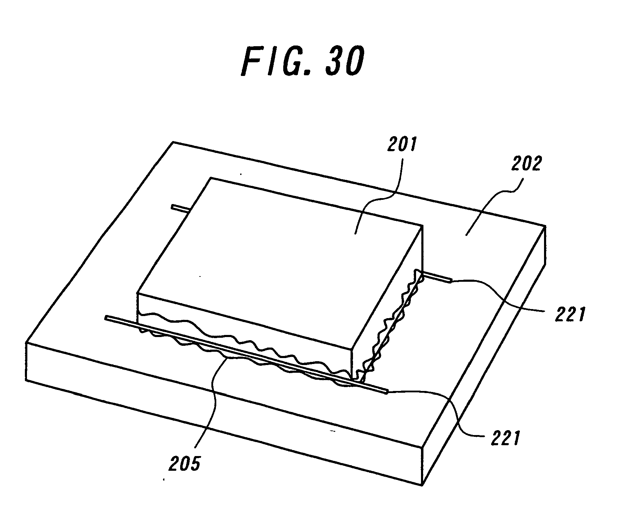

In the case that the shield case mentioned above is assembled on the circuit board, as shown in Fig. 23 (Fig. 30), ground wires (ground patterns) are formed on the circuit board at portions corresponding to lower ends of the shield case and their surrounding portions, and the ground wires and a part of or an overall of the lower ends of the shield case are connected by brazing.

In the case that the shield case and the ground wires of the circuit board are connected in the same manner as that of the known method mentioned above, the following problems occur inevitably:
① Affection for printed circuit board and electric parts due to the heat of the brazing operation (deformation or partial fracture);
② Operation inefficiency for removing the brazing material from the metal case, when the shield case is to be recycled on the circuit board that expires the duration period;
③ Complicated operation such as a washing operation before and after the brazing;
④ Adhesion of the brazing material to the other circuit elements due to a scattering of the flux and the brazing material itself during the brazing operation; and
⑤ Complicated operation for breaking the connection by the brazing, when the electric parts in the shield case are to be exchanged (In order to overcome the problem ⑤ mentioned above, there is the case that, as the shield case, use is made of a shield case of so-called two-piece type having a lower truss and an upper cap arranged detachably to the truss. In this case, the two-piece shield case is liable to be large in height and obstructs a thin construction on the circuit board. In addition, it is not possible to overcome the problem such that the manufacturing cost is high.

DE 198 42 028 A1 discloses a generic setting construction of a shield case on a circuit board, wherein a pin is arranged to a peripheral end of the shield case made of metal, and a hole is arranged to an outer casing.

Further prior art references are EP-A-1 137 099 showing an antenna connector, and US-4 111 518 showing a wiring-connector device.

It is the object of the present invention, to provide a simplyfied setting construction of a shield case on a circuit board.

This object is solved by the setting construction of a shield case on a circuit board having the features of claim 1. The invention is further developed, as it is defined in the dependent claims.

For reference, the present invention will be explained with reference to the following figures:
Fig. 1 is a perspective view showing a known connection structure between a planar antenna and a circuit board;
Fig. 2 is a perspective view illustrating a first example of the connection structure between the planar antenna and the circuit board not belonging to the invention;
Fig. 3 is a cross sectional view depicting an inserting state between a spring pin and a through hole of the first example;
Fig. 4 is a plan view showing a construction of the spring pin;
Figs. 5A-5C are cross sectional views respectively illustrating one example of the spring pin;
Fig. 6 is a perspective view depicting a planar antenna used in a second example of the connection structure between the planar antenna and the circuit board not belonging to the invention;
Fig. 7 is a perspective view showing the planar antenna used in a third example of the connection structure between the planar antenna and the circuit board not belonging to the invention;
Fig. 8 is a perspective view illustrating the planar antenna used in a fourth example of the connection structure between the planar antenna and the circuit board not belonging to the invention;
Fig. 9 is a perspective view depicting a detailed construction of a pressure-connection terminal of the fourth example;
Fig. 10 is a perspective view showing the fourth example of the connection structure between the planar antenna and the circuit board;
Fig. 11 is a perspective view illustrating the planar antenna used in a fifth example of the connection structure between the planar antenna and the circuit board not belonging to the invention;
Fig. 12 is a perspective view depicting a construction of the circuit board of the fifth example;
Fig. 13 is a graph showing a return loss property both in the case that a film is laminated on the planar antenna and in the case that the film is not
laminated;
Fig. 14 is a perspective view illustrating a sixth example of the connection structure between the planar antenna and the circuit board not belonging to the invention in a disassembled manner;
Figs. 15A-15D are cross sectional views respectively depicting an example of the connection structure between the planar antenna and a housing;
Fig. 16 is a graph showing a relation between a contact pressure and the return loss property;
Figs. 17A and 17B are schematic views respectively illustrating another example of the spring pin;
Fig. 18 is a cross sectional side view depicting a construction of an example 1 of a setting construction of a shield case on the circuit board not belonging to the invention;
Fig. 19 is a cross sectional side view showing a construction of an example 2 not belonging to the invention;
Fig. 20 is a cross sectional side view illustrating a construction of an embodiment 1;
Figs. 21A and 21B are cross sectional side views respectively depicting a construction such that a distance between anchor pins is designed to deviate from a distance between the through holes, thereby pressing a side portion of the through hole with a pressing pressure by a side portion of the anchor pin, wherein A shows a design where the anchor pin is not projected from the through hole and B illustrates a design where the anchor pin is projected from the through hole;
Figs. 22A and 22b are cross sectional side views respectively depicting a construction such that the anchor pin is divided into plural pieces in a longitudinal direction and a diameter of the anchor pin is designed to be little larger than that of the through hole, thereby pressing a side portion of the through hole with a pressing pressure by a side portion of the anchor pin, wherein A shows a design where the anchor pin is not projected from the through hole and B illustrates a design where the anchor pin is projected from the through hole;
Fig. 23 is a perspective view depicting a known technique of connecting the shield case to the circuit board by brazing;
Fig. 24 is a cross sectional side view showing a construction of an embodiment 2 of the setting construction of the shield case on the circuit board with an outer casing according to the invention;
Fig. 25 is a cross sectional side view illustrating a construction of an embodiment 3;
Fig. 26 is a cross sectional side view depicting a construction of an embodiment 4;
Fig. 27 is a cross sectional side view showing a construction of an embodiment 5;
Figs. 28A and 28B are cross sectional side views respectively illustrating a construction such that a distance between lock pins is designed to deviate from a distance between the through holes, thereby pressing a side portion of the through hole with a pressing pressure by a side portion of the lock pin, wherein A depicts a design where a diameter of the through hole is even and B shows a design where the through hole has a two step construction such that an upper diameter is larger than a lower diameter;
Figs. 29A and 29B are cross sectional side views respectively depicting a construction such that the anchor pin is divided into plural pieces in a longitudinal direction and a diameter of the anchor pin is designed to be little larger than that of the through hole, thereby pressing a side portion of the through hole with a pressing pressure by a side portion of the anchor pin, wherein A depicts a design where a diameter of the through hole is even and B shows a design where the through hole has a two step construction such that an upper diameter is larger than a lower diameter; and
Fig. 30 is a perspective view illustrating a known technique of connecting the shield case to the circuit board by brazing.

Fig. 2 is a perspective view showing a first example of a connection structure between a planar antenna installed in a wireless device and a circuit board not belonging to the invention. In this example, a power supply spring pin, a short circuit spring pin and a connection spring pin construct respectively an elastically bending pin, and a power supply hole, a short circuit hole and a connection hole construct respectively an through hole. In addition, a housing constructs an outer casing. A planar antenna 10 of this example is integrally formed parts made of a metal plate having a thickness of 0.15 mm. The planar antenna 10 comprises a planar antenna element 11 having a dimension in a longitudinal direction of 35 mm and a dimension in a lateral direction of 15 mm, a power supply strip 12 and a short circuit strip 13 formed by bending two thin strips projected from one lateral side end of the antenna element in a substantially vertical direction with respect to a plane of the planar antenna element, and a power supply / connection spring pin 14 and a short circuit / connection spring pin 15 that are elastically deformable by a bending stress, which are formed at tip portions of the power supply strip 12 and the short circuit strip 13. A height of the planar antenna 10 is 5 mm.

A power supply circuit and a short circuit, to which the power supply spring pin 14 and the short circuit spring pin 15 are electrically connected, are formed on a surface of a circuit board 21 by means of a printed wiring, but they are omitted in Fig. 2. A power supply / connection hole 22 and short circuit/connection hole 23 are formed to the circuit board 21 at portions corresponding to the power supply / connection spring pin 14 and the short circuit / connection spring pin 15, which are used when the planar antenna 10 is connected to the circuit board 21.

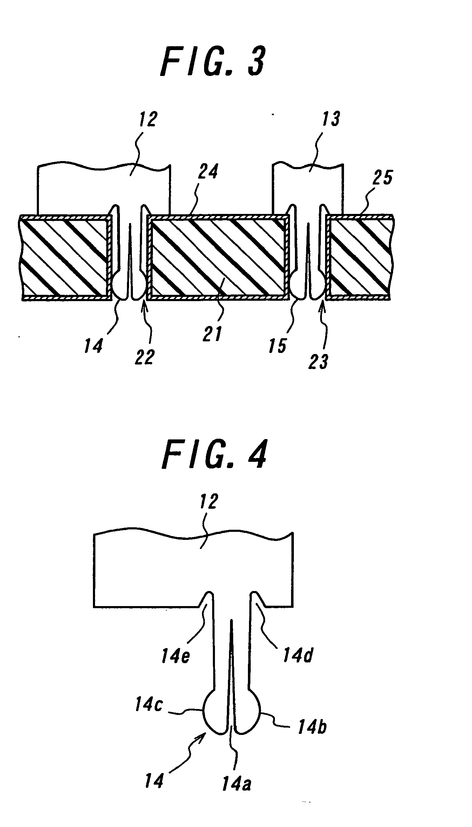

Fig. 3 is an enlarged cross sectional view showing a part of the circuit board 21 to which the power supply / connection hole 22 and the short circuit / connection hole 23 are formed. A power supply conductive layer 24 and a short circuit conductive layer 25, which are connected respectively to the power supply circuit and the short circuit, are formed on inner walls of the power supply / connection hole 22 and the short circuit / connection hole 23. When the planar antenna 10 and the circuit board 21 are connected, the power supply / connection spring pin 14 and the short circuit / connection spring pin 15, which are formed to the planar antenna, are inserted respectively into the corresponding power supply / connection hole 22 and the corresponding short circuit / connection hole 23. In this example, the power supply / connection hole 22 and the short circuit / connection hole 23 have a circular cross section having a diameter of about 0.8 mm. However, the shape of theses holes may be changed to an oval shape and a slit shape corresponding to a shape of the spring pin.

As shown in Fig. 4, the power supply / connection spring pin 14 is divided by a center slit 14a and its tip portion is formed by a pair of projections 14b and 14c, which widens its tip portion. A length of each projections is substantially equal to a thickness of the circuit board 21 i.e. 0.9 mm. If the power supply / connection spring pin 14 is inserted into the corresponding power supply / connection hole 22 formed to the circuit board 21, the projections 14b and 14c are elastically deformed by a bending stress in such a manner that they are closed with each other, and outer ends of the projections are contacted with pressure to the power supply conductive layer 24 as shown in Fig. 3. In this example, since the power supply / connection spring pin 14 is not deformed in a thickness direction of the metal plate but deformed in a direction substantially vertical to the thickness direction, an extraordinarily large bending elastic force occurs, and thus the power supply spring pin can be contacted with a large pressure to the power supply conductive layer. Moreover, in order to generate such bending elastic force easily, cutout portions 14d and 14e are formed respectively to base portions of the projections 14b and 14c. Therefore, an electrically stable and low resistive connection can be obtained, and a mechanically strong connection can be also obtained. As well, the short circuit / connection spring pin 15 is constructed as is the same manner as that of the power supply / connection spring pin 14 mentioned above, and thus an excellent electrical and mechanical connection to the short circuit conductive layer 25 arranged to the inner wall of the short circuit / connection hole 23 can be achieved.

Moreover, the power supply / connection spring pin 14 and the short circuit / connection pin 15 can be extracted respectively from the power supply / connection hole 22 and the short circuit / connection hole 23 by applying a strong force in a direction wherein the planar antenna 10 and the circuit board 21 are separated with each other. In this case, it is easy to exchange the planar antenna. Further, in the case that the wireless device which expires its durable period is disposed, the planar antenna 10 and the circuit board 21 can be easily disassembled, and thus a recycling cost can be decreased.

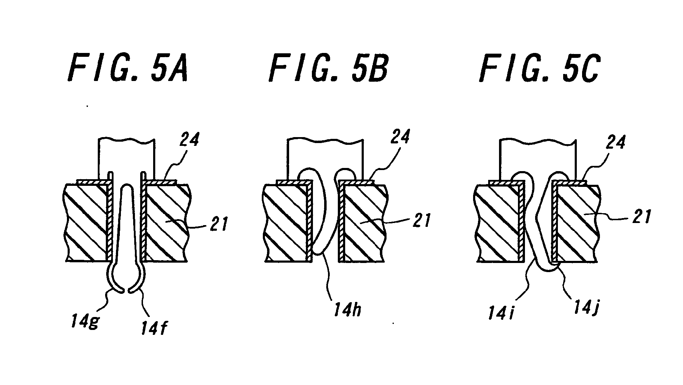

Figs. 5A - 5C show various shapes of the power supply spring pin 14. In the example shown in Fig. 5A, two projections 14f and 14g are worked respectively into a semicylinder shape. Moreover, lengths of these projections are designed to be longer than a thickness of the circuit board so as to project its tip portion from a rear surface of the circuit board 21. In this example, the number of the projections is two, but it is possible to set the number of the projections to three or four. In the case of using the power supply / connection spring pin having the shape mentioned above, a shape of the power supply / connection spring pin formed to the circuit board is designed to be circular.

In the example shown in Fig. 5B, a projection 14h has a curved shape. In a free state, the curved shape has a larger curvature as compared with the curvature shown in Fig. 5B. Therefore, a tip portion of the projection 14h and a side end near the base portion are contacted with pressure to the conductive layer 24 by a strong bending elastic force generated by a returning motion from the state shown in Fig. 5B to the free state.

Also in the example shown in Fig. 5C, a projection 14i has a curved shape. In this example, a length of the projection 14i is designed to be longer than a thickness of the circuit board 21, so that a hook portion 14j projected outward from the power supply / connection hole 22 gets stuck on a rear surface of the circuit board. Therefore, the connection between the planar antenna 10 and the circuit board 21 is not easily broken.

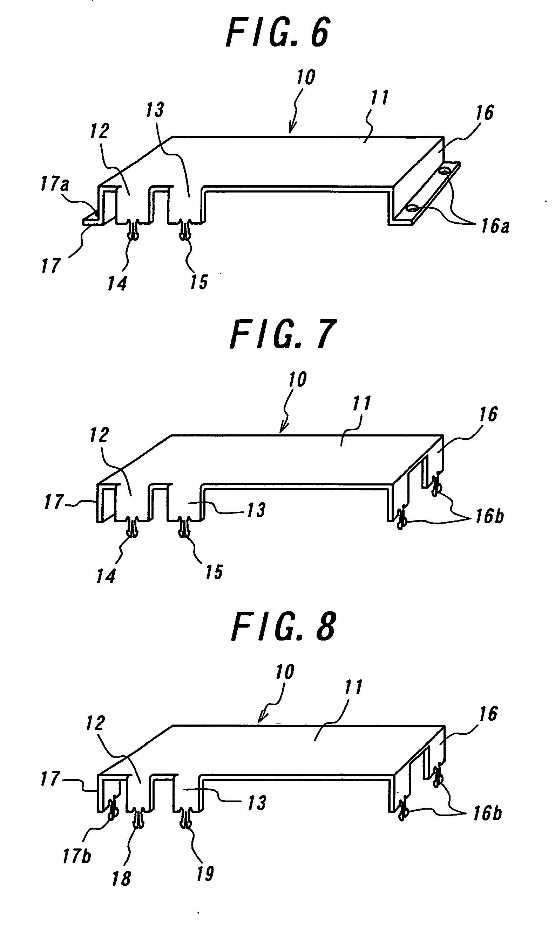

Fig. 6 is a perspective view showing the planar antenna used in the second example of the connection structure between the planar antenna and the circuit board not belonging to the invention. In this example, portions similar to those of the first example of the planar antenna 10 mentioned above are denoted by the same reference numerals as those of the first example. In this example, ribs 16 and 17 for reinforcing, which are formed by bending both side ends in a longitudinal direction of the planar antenna element 11, are arranged. Heights of these ribs 16 and 17 are 5 mm. Moreover, in this example, tip portions of the ribs 16 and 17 for reinforcing, which are formed to both side ends in a longitudinal direction of the planar antenna element 11, are bent in parallel with a surface of the planar antenna element 11, and a plurality of holes 16a and 17a are formed to the bent portions. In the case of assembling the planar antenna 10 and the circuit board 21, it is possible to perform an accurate positioning between the planar antenna 10 and the circuit board 21 by inserting projections formed at corresponding portions on a surface of the circuit board 21 into the holes 16a and 17a respectively.

Fig. 7 is a perspective view showing the planar antenna used in the third example of the connection structure between the planar antenna and the circuit board not belonging to the invention. Also in this example, portions similar to those of the first example of the planar antenna mentioned above are denoted by the same reference numerals as those of the first example, and the explanations thereof are omitted here. In this example, a plurality of connection spring pins 16b and 17b are formed respectively to the tip portions of the ribs 16 and 17 for reinforcing, which are formed to both side ends in a longitudinal direction of the planar antenna element 11. In Fig. 7, the connection spring pin 17b formed to a left side rib 17 is not shown. In the case of assembling the planar antenna 10 and the circuit board 21, the connection spring pins 16b and 17b mentioned above are elastically inserted with a bending pressure into connection holes formed at corresponding portions on a surface of the circuit board 21. Since conductive layers are not arranged to the connection holes of the circuit board 21 to which the connection spring pins 16b and 17b are inserted, characteristics of the planar antenna 10 are not affected. As mentioned above, in this example, since the connection spring pins 16b and 17b for connecting mechanically the planar antenna 10 and the circuit board 21 are arranged other than the power supply / connection spring pin 14 and the short circuit / connection spring pin 15, a further strong connection between the planar antenna and the circuit board can be achieved.

Fig. 8 is a perspective view showing the planar antenna used in the fourth example of the connection structure between the planar antenna and the circuit board not belonging to the invention. Also in this example, portions similar to those of the first example of the planar antenna mentioned above are denoted by the same reference numerals as those of the first example, and the explanations thereof are omitted here. In this example, the construction such that a plurality of connection spring pins 16b and 17b are formed respectively to the tip portions of the ribs 16 and 17 for reinforcing, which are formed to both side ends in a longitudinal direction of the planar antenna element 11, is the same as that of the third example shown in Fig. 7. In this example, a power supply pressure-connection terminal 18 and a short circuit pressure-connection terminal 19 are formed respectively to tip portions of the power supply strip 12 and the short circuit strip 13 formed by bending a thin strip projected from one side end in a longitudinal direction of the planar antenna element 11.

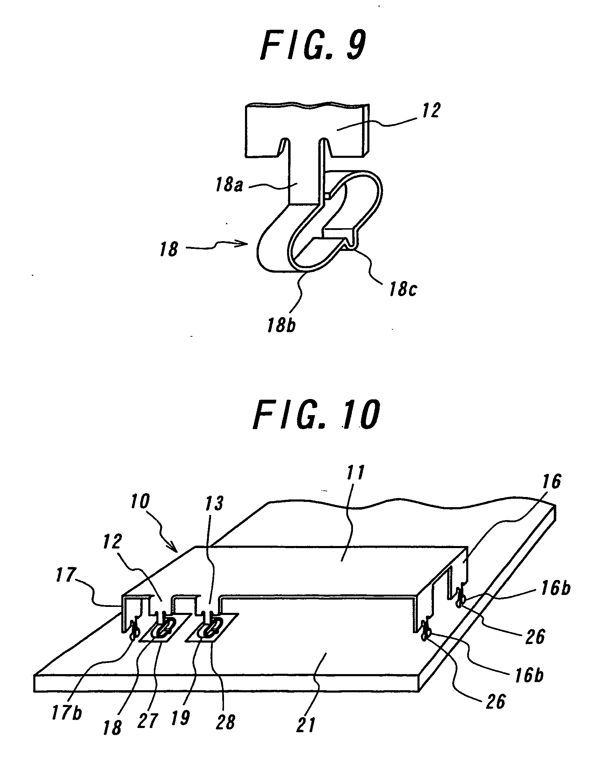

Fig. 9 is a perspective view showing a detailed construction of the power supply pressure-connection terminal 18. In this example, the power supply pressure-connection terminal 18 comprises: a base portion 18a, which is connected continuously to the power supply strip 12 and has a narrow width as compared with that of the power supply strip 12; and an elastically deformable portion 18b by a bending stress having an elliptic shape, which is connected continuously to a tip portion of the base portion 18a. Moreover, a curved portion 18c having a large curvature is formed at a substantially center portion of the elastically deformable portion 18b by a bending pressure. The shape of pressure-connection terminal is not limited, and various variations may be used. For example, use may be made of a plate spring having U-shape, racetrack shape, arc shape or V-shape. That is, use may be made of a shape if a necessary contact pressure can be obtained by the applied bending deformation.

Fig. 10 is a perspective view showing a state such that the planar antenna 10 mentioned above and the circuit board 21 are assembled. The connection spring pins 16b and 17b formed to the tip portions of the ribs 16 and 17 for reinforcing, which are arranged at both sides in a longitudinal direction of the planar antenna element 11 of the planar antenna 10, are elastically inserted with a bending pressure into the connection holes 26 formed at the corresponding portions of the circuit board 21, and this connection can be easily released.
In this case, the power supply pressure-connection terminal 18 and the short circuit pressure-connection terminal 19 of the planar antenna 10 are respectively contacted with pressure to a power supply conductive pad 28 and a short circuit conductive pad 28 arranged at corresponding portions on a surface of the circuit board 21, thereby connecting them electrically. In this case, since the connection is performed by inserting the connection spring pins 16b and 17b into the connection holes 26, a large connection force can be obtained. Moreover, since, as shown in Fig. 9, the curved portion 18c projected outward is formed to the tip portion of the power supply pressure-connection terminal 18 and the short circuit pressure-connection terminal 19 has the same construction as that of the power supply pressure-connection terminal 18, a low resistive and an electrically stable contact can be obtained.

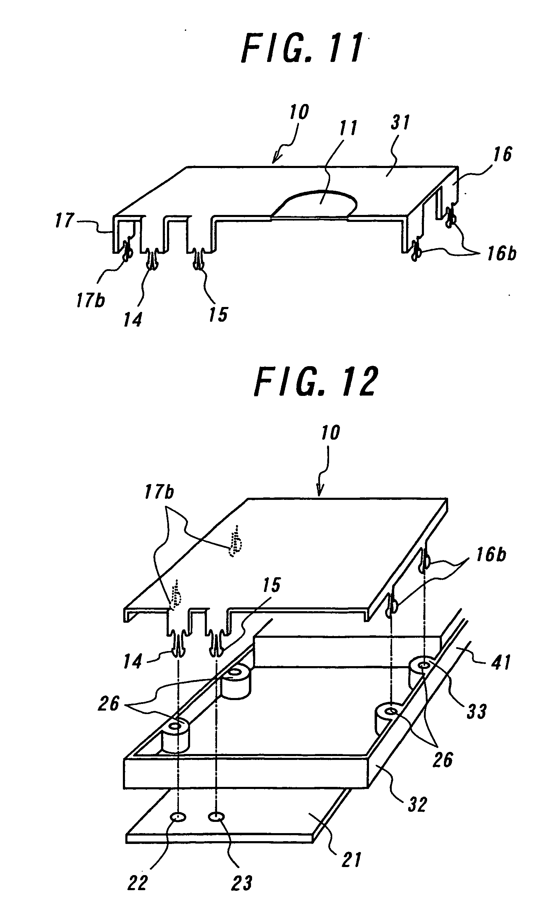

Figs. 11 and 12 are perspective views showing respectively the planar antenna and the circuit board used in the fifth example of the connection structure between the planar antenna and the circuit board not belonging to the invention. In this example, as shown in Fig. 11, the planar antenna 10 comprises: the power supply / connection spring pin 14 and the short circuit / connection spring pin 15 formed respectively to the tip portions of the power supply strip 12 and the short circuit strip 13; and a plurality of connection spring pins 16b and 17b formed to the tip portions of the reinforcing ribs 16 and 17 which are formed by bending the both side ends in a longitudinal direction of the planar antenna element. Further, in the planar antenna 10 of this example, a film 31 made of an electrically insulation material is laminated on a font and a rear surfaces thereof. In this example, this laminated film 31 is formed by polyimide, but use may be made of the other resins having an electrically insulation characteristic.

Moreover, as shown in Fig. 12, in the circuit board 21, the power supply / connection holes 22 and 23, to which the power supply / connection spring pin 14 and the short circuit / connection spring pin 15 mentioned above are inserted, are formed at the portions corresponding to respective spring pins.

A reinforcing frame 32 of the planar antenna 10 formed integrally with a housing 41 is arranged on the circuit board 21 to which the planar antenna 10 is assembled. In addition, a plurality of ribs 33 each having the connection hole 26, to which the connection spring pin 16b or 17b is inserted, are arranged to the reinforcing frame 32. In the wireless device wherein all the parts are assembled, the circuit board 21 and the housing 41 are to be connected directly or via an intermediate member in a mechanically fixed manner. Therefore, if the planar antenna 10 and the reinforcing frame 32 formed integrally with the housing are connected in the manner as shown in Fig. 12, it is possible to eliminate a mechanical connection between the planar antenna and the circuit board 21. Moreover, use may be made of the power supply pressure-connection terminal 18 and the short circuit pressure-connection terminal 19 as a substitute for the power supply / connection spring pin 14 and the short circuit / connection spring pin 15 of the planar antenna 10. The laminated film 31 functions to improve a mechanical strength of the planar antenna 10 and protect the planar antenna from an external damage. Therefore, it is possible to make a thickness of the metal plate constituting the planar antenna 10 thinner as compared with the known one. Further, in the case that the planar antenna is designed to take a complicated shape having a cutout portion or a slot portion or take a thinner shape for the purpose of achieving a light weight by making it small or thin, the laminated film reinforces the metal plate, and thus it is possible to reduce the number of connection portions as compared with the case using no laminated film and to achieve an excellent mechanical shock resistance. These properties are important as the cellular phone terminal.

In this example, a front surface and a rear surface of the planar antenna 10 are covered with the film 31 made of polyimide as mentioned above. In this case, if a thickness of the film is designed to be thicker too much, an impedance of the planar antenna is varied from a target impedance value. Contrary to this, if a thickness of the film is designed to be thinner too much, it is not possible to achieve a sufficient electrically insulation property and a sufficient mechanical strength.

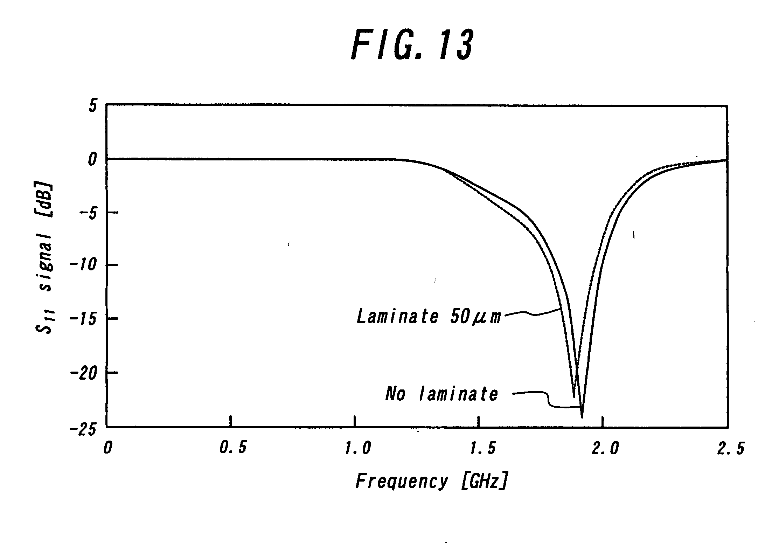

Fig. 13 is a graph showing a comparison between a return loss in the case of arranging the laminated film having a thickness of 50 µm and a return loss in the case of arranging no laminated film. It is understood from Fig. 13 that an impedance variation of the planar antenna due to the laminated film is small. Further, an excellent electrically insulation property and an excellent mechanical strength can be maintained if the laminated film is arranged. Therefore, the laminated film having the thickness mentioned above is particularly preferable. In this case, it is desirable to make a thickness of the laminated film thinner and thinner if the electrically insulation property and the mechanical strength are maintained. However, if a thickness of the laminated film is less that 1 µm, the electrically insulation property and the mechanical strength are not sufficient, and a film forming operation and a laminating operation to the planar antenna are very troublesome. Therefore, it is not preferred. After various examinations, it is confirmed that, if a thickness of the laminated film is not larger than 200 µm, a return loss of larger than 9.54 dB (voltage SWR is not larger than 2) can be obtained on a bandwidth of 170 MHz, and a thickness of the laminated film is preferably determined from the viewpoint of an excellent electrically insulation property and an excellent mechanical strength can be maintained.

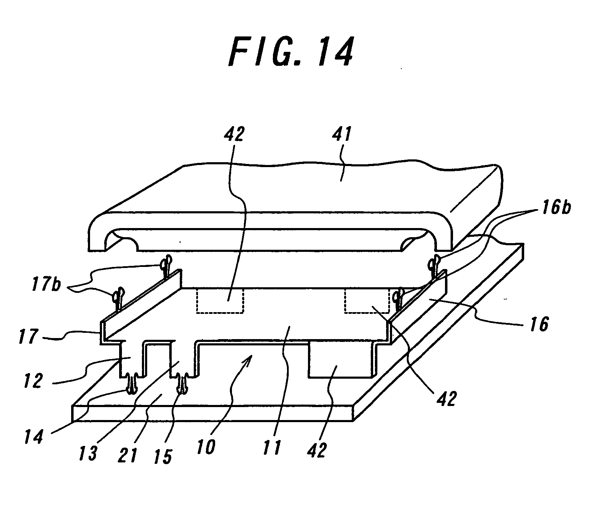

Fig. 14 is a perspective view showing the planar antenna, the circuit board and the housing in a disassembled manner, which are used in the sixth example of the connection structure between the planar antenna and the circuit board not belonging to the invention. In this example, the reinforcing ribs 16 and 17 are formed by bending both side ends in a longitudinal direction of the planar antenna 10 in a direction opposed to the circuit board 21 in a substantially vertical manner i.e. in a direction faced to the housing 41, and the plural connection spring pins 16b and 17b for connecting the planar antenna 10 and the housing 41 are integrally formed to the tip portions of these ribs. It is not shown in Fig. 14, but the connection holes, to which the connection spring pins 16b and 17b mentioned above are inserted in a bending elastic manner, are formed at corresponding portions of the housing 41 on a surface faced to the planar antenna 10.

In this example, in the planar antenna 10, the power supply / connection spring pin 14 and the short circuit / connection spring pin 15 are formed to the tip portions of the power supply strip 12 and the short circuit strip 13, and these pins are respectively inserted in a bending elastic manner to the power supply / connection hole 22 and the short circuit / connection hoe 23 formed at corresponding portions of the circuit board 21, thereby connecting them electrically and mechanically. Further, a plurality of reinforcing ribs 42 bending to a side of the circuit board are formed to side ends of the planar antenna 10.

In the wireless device wherein all the parts are assembled, the circuit board 21 and the housing 41 are to be connected directly or via an intermediate member in a mechanically fixed manner. Therefore, if the planar antenna 10 and the housing 41 are connected in the manner as shown in Fig. 14, it is possible to eliminate a mechanical connection between the planar antenna and the circuit board 21. Moreover, use may be made of the power supply pressure-connection terminal 18 and the short circuit pressure-connection terminal 19 as a substitute for the power supply / connection spring pin 14 and the short circuit / connection spring pin 15 of the planar antenna 10 as shown in Fig. 8.

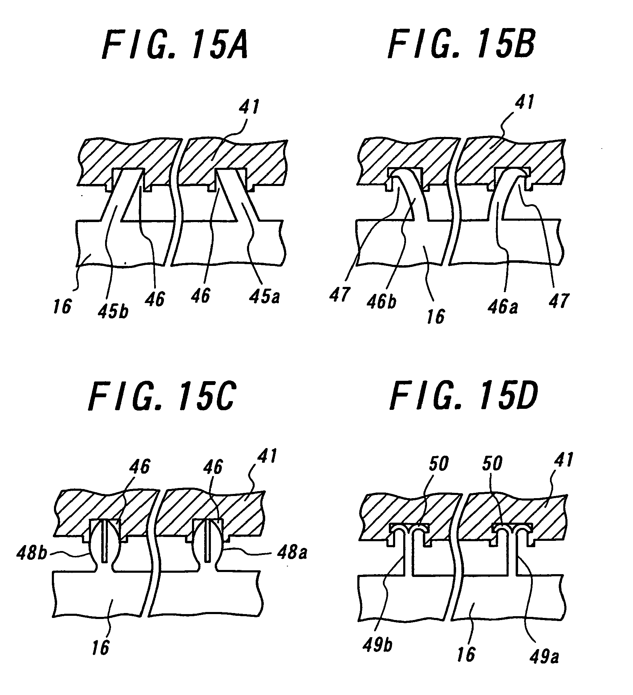

Figs. 15A - 15D are schematic views respectively showing another example of the connection structure for connecting detachably the planar antenna 10 and the housing 41. In the example shown in Fig. 15A, linear projections 45a and 45b are formed to the reinforcing rib 16 of the planar antenna 10 in such a manner that they are inclined inwardly with each other, and concave portions 46 are formed at corresponding portions of the housing 41. In this case, since resilient forces of the projections 45a and 45b, which are inserted into the concave portions 46 in a bending elastic manner, act outwardly with each other, it is possible to connect firmly the planar antenna 10 and the housing 41.

In the example shown in Fig. 15B, projections 47a and 47b having outwardly curved shapes with each other are formed to the reinforcing rib 16 of the planar antenna 10 in an outwardly inclined manner with each other, and concave portions 48 formed at corresponding portions of the housing 41 are extended outwardly with each other near its bottom portion so as to permit insertions of tip portions of the projections 47. In this case, since resilient forces of the projections 47a and 47b, which are inserted into the concave portions 46 in a bending elastic manner, act inwardly with each other, it is possible to connect firmly the planar antenna 10 and the housing 41. In addition, since the tip portions of the projections get stuck on the concave portions, there is an advantage such that the projections are not easily extracted from the concave portions.

In the example shown in Fig. 15C, projections 48a and 48b each having a slit portion are formed to the reinforcing rib 16 of the planar antenna 10, and are inserted in a bending elastic manner into the concave portions 46 formed at corresponding portions of the housing 41. Moreover, in the example shown in Fig. 15D, projections 49a and 49b each having a bifoliate tip portion are formed to the reinforcing rib 16 of the planar antenna 10, and are inserted in a bending elastic manner into concave portions 50 of the housing 41 whose bottom portions are extended in both sides. In this case, since the projections 49a and 49b get stuck on the bifoliate tip portion of the projections 50, there is an advantage such that the projections are not easily extracted from the concave portions.

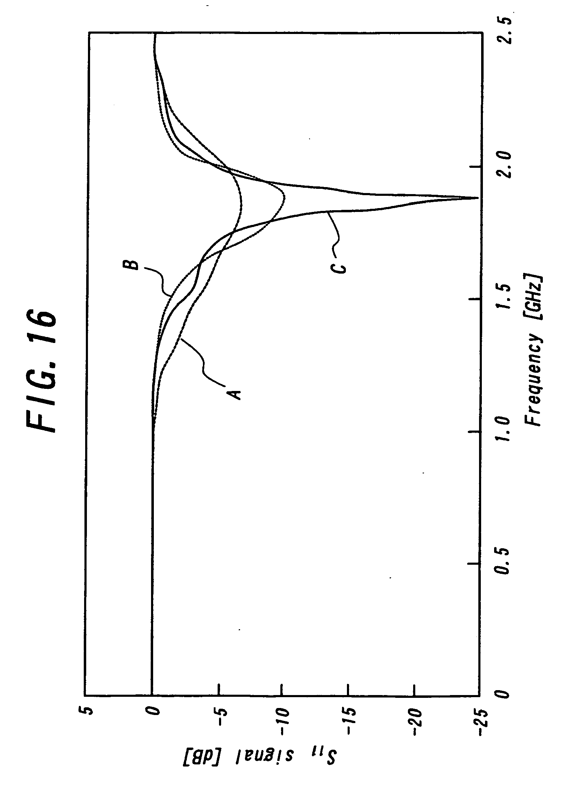

As mentioned above, in the connection structure between the planar antenna and the circuit board wherein the power supply spring pin 14 and the short circuit spring pin 15 formed to the planar antenna are inserted into the corresponding power supply / connection hole 22 and the corresponding short circuit / connection hole 23 formed to the circuit board 21, it is possible to obtain an extraordinarily larger contact pressure between, the power supply spring pin 14 and the short circuit spring pin 15, and, the power supply conductive layer 24 and the short circuit conductive layer 25 formed respectively to inner walls of the power supply / connection hole 22 and the short circuit / connection hole 23. For example, when the contact pressure was measured in the example shown in Figs. 2 and 3, the measured contact pressure was about 1.81 N. On the other hand, a contact pressure measured in the known connection structure wherein they are only inserted and no brazed with each other was about 0.78 N. Fig. 16 is a graph showing a return loss of A, B and C in a relation between frequency (horizontal axis) and signal intensity (vertical axis), wherein A, B and C show respectively contact pressures of 0.78 N, 1.0 N and 1.81 N. From the results of various antenna characteristic tests, it is understood that the practical antenna having a return loss of not less than 9.54 dB (Voltage SWR: not less than 2) and a bandwidth of not less than 170 MHz can be obtained, if the contact pressure is not less than 1.0 N. As one example, the contact pressure measured in the example shown in Fig. 10, wherein use is made of the pressure-connection terminal, was 1.13 N.

As mentioned above, in order to obtain a large contact pressure of not less than 1.0 N, it is effective to form the planar antenna by a metal having excellent mechanical properties such as maximum fracture strength, yield strength and Young's modulus for obtaining spring properties. Moreover, as a metal for the planar antenna used in the embodiment wherein not only mechanical connection but also electric connection are performed, it is necessary to use a metal having not only mechanical properties mentioned above but also high electric conductivity. As a metal satisfying the above conditions, use may be made of brass, phosphorus bronze, nickel copper, titanium copper, Corson alloy or beryllium copper.

For example, in the examples mentioned above, a spacer having an electrically insulation property is not used, but a supporting member being independent upon the housing may be arranged between the planar antenna and the circuit board. For example, in the example shown in Figs. 11 and 12, the spacer having an electrically insulation property may be used instead of a part of the housing.

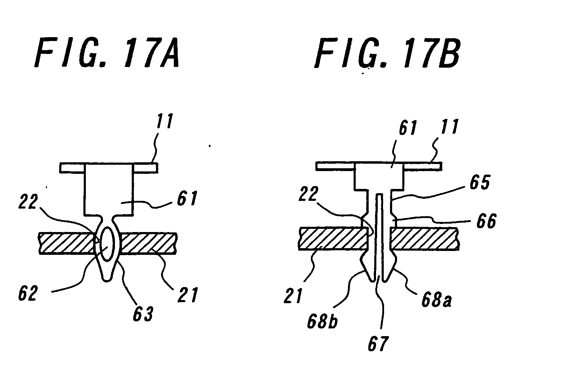

Further, the constructions of the power supply spring pin, the short circuit spring pin and the connection spring pin shown in the examples mentioned above are not limited, but the other constructions may be used if the necessary contact pressure due to the bending elastic deformation may be obtained. For example, as shown in Fig. 17A, use may be med of a projection 63 having an opening 62 at its center portion, which is continued from a power supply strip 61 formed integrally with the planar antenna element 11. In this case, the projection 63 is contacted with a large pressure to an inner wall of the hole 22 formed to the circuit board 21 by bending both side portions of the projection 63 corresponding to the opening 62 in an elastically deformable manner.

Moreover, Fig. 17B shows another embodiment of the power supply spring pin shown in Fig. 4. In a power supply spring pin 64 of this example, a flange 66 is continued to a power supply strip 61 formed integrally with the planar antenna element 11, and tip portions 68a and 68b are divided by means of a slit 67. In this case, s size of the flange 66 is designed to be larger than that of the hole 22, to which the power supply spring pin 64 is inserted in a bending elastic manner. Therefore, in the case such that the power supply spring pin is inserted into the hole, it is possible to insert the power supply spring pin at a predetermined depth by inserting it to a level at then a lower side of the flange 66 is contacted to a surface of the circuit board 21, so that it is possible to set an interval between the planar antenna 10 and the circuit board 21 automatically to a predetermined value.

In the setting construction of a shield case on the circuit board, as clearly understood from the above explanations, a plurality of anchor pins 111 formed integrally with a shield case 101 are inserted into through holes 122 of the circuit board 102, and a side portion of the anchor pin 111 presses elastically a side portion of the through hole 122. In this manner, thee shield case 101 and the circuit board 102 are firmly connected, so that the shield case 101 is set on the circuit board 102. In this example, the anchor pin constructs the bending elastic pin.

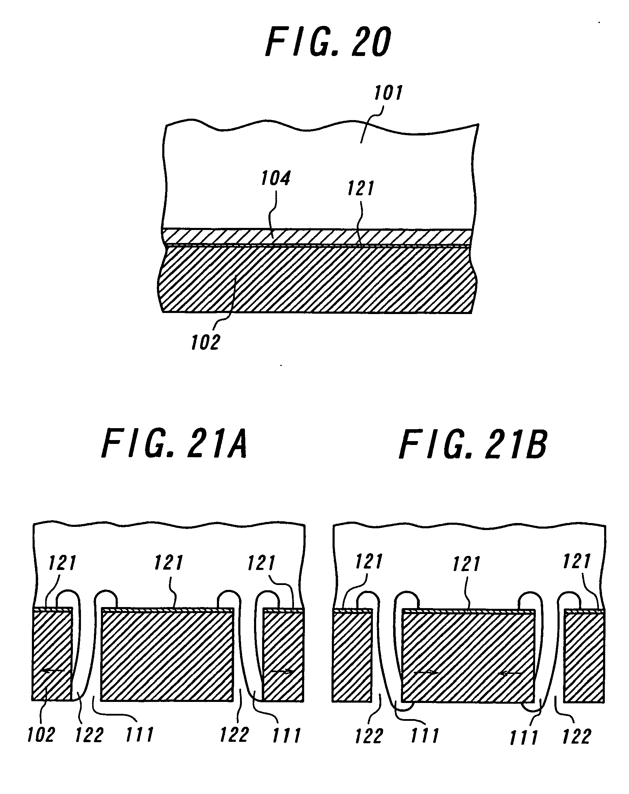

In order to achieve the setting construction mentioned above, as shown in Figs. 21A and 21B, an interval between the anchor pins 111 having a bending elastic property and an interval between the through holes 122 of the circuit board 102 are designed to be not equal but slightly deviated. In this case, the anchor pin 111 inserted into the through hole 122 is elastically deformed on the basis of the bending elastic property in a right direction or in a left direction, and the side portion of the anchor pin 111 presses the side portion of the through hole 122. Moreover, as shown in Figs. 22A and 22B, the anchor pin 111 having a bending elastic property is divided in a longitudinal direction into plural pieces. In addition, in a normal state, a diameter of the anchor pin 111 is designed to be slightly larger than that of the through hole 122. Therefore, in the case that the anchor pin 111 is inserted into the through hole 122, the anchor pin is elastically deformed on the basis of the bending elastic property at both sides of the divided anchor pin, and the side portion of the anchor pin 111 presses the side portion of the through hole 122.

Among the examples shown in Figs. 21A, 21B, 22A and 22B, in the examples shown in Figs. 21A and 22A, the anchor pin 111 is not protruded from the through hole 122. In the examples shown in Figs. 21B and 22B, the anchor pin 122 is protruded from the through hole 122 to a rear surface of the circuit board 102, and further a protruded portion is existent in a direction of the side portion of the through hole 122.

In the examples shown in Figs. 21B and 22B, the protruded portion functions to connect the shield case 101 and the circuit board 102 more firmly.
In the examples shown in Figs. 21A, 21B, 22A and 22B, the through hole 122 has an opening at a lower side of the circuit board 102, but a design of the through hole 122 is not limited to theses examples. The other design such that the lower side of the circuit board 102 is closed may be used (in this case, it is not possible to perform the case such that the anchor pin 111 is protruded from the through hole 122 as shown in Figs. 21B and 22B).

As the shield case 101, a box type is normally used which are constructed by an upper surface and four side portions opposed with each other, but the shield case 101 is not necessarily limited to such a shape.

That is, for example, it is technically possible to use the shield case 101 having a dome shape such as koh-rakuen baseball stadium.

On the other hand, the metal plate used for the shield case 101 is formed integrally and is worked by a so-called press molding in numerous cases. However, the working method is not necessarily limited to the press molding, and, for example, it is possible to take a design such that a thin metal plate covers a skeleton having a truss structure.

The connection using the braze (known technique) is not used by performing the connection such that the anchor pin 111 is inserted into the through hole 122 of the circuit board 102. Therefore, the drawbacks mentioned previously in the ① - ⑤ sections can be cleared.

Since the connection using the brazing is not used, a slight gap (space) is necessarily generated between a lower end of the shield case 101 and the ground wire 121 of the circuit board 102.

However, at least a part of the shield case 101 or the anchor pin 111 and the ground wire 121 of the circuit board 102 are electrically connected. In this case, since the shield case 101 and the ground wire 121 have substantially same potential, it is possible to take a design such that a leakage of electric field at the gap can be decreased. Moreover, since the integrality of the connection can be achieved, it is possible to take a design such that a leakage of electromagnetic wave can be decreased.

The electrical connection mentioned above can be achieved by connecting directly at least a part of the lower end of the shield case 101 or the anchor pin 111 and the ground wire 121, or by connecting them indirectly via a conductive member such as metal.

Even if the slight electromagnetic wave is leaked outward via the gap, the external circuits are not necessarily affected.

That is, a level of the leaked electromagnetic wave corresponds to a level of the gap, levels of wavelength and amplitude of the electromagnetic wave, and a size of the shield case 101. However, it is known from various tests that affection for the external circuit parts due to the leaked electromagnetic wave can be prevented by taking a design such that the connection between the shield case 101 and the circuit board 102 based on the insertion of the anchor pin 111 is made closer so as to minimize the gap.

Moreover, since semiconductors such as power amplifier for a high frequency circuit are assembled in the shield case 101, the electric parts in the shield case 101 generate heat.

In order to prevent a deterioration of the electric parts itself due to such a heat, a plurality of small holes are sometimes formed to the shield case 101.

Moreover, in order to prevent a leakage of electromagnetic wave from these plural small holes, it is necessary to make a diameter of each small holes fine ( a fine level of the diameter corresponds to levels of wavelength and amplitude of the electromagnetic wave). However, if a diameter design is too fine, a ventilation property of the shield case 101 is decreased and a heat prevention property is extremely insufficient. In addition, a leakage of electromagnetic wave from the small holes is remarkably increased sometimes.

As mentioned above, the connection between a lower end of the shield case 101 and the ground wire 121 is sufficiently made closer. In addition, use is made of high heat-conductive spring copper or copper alloy as the shield case 101. Therefore, it is possible to take a design such that no small holes for heat radiation are arranged.

A contact level between the shield case 101 and the circuit board 102 i.e. a level of the gap corresponds to an interval between the anchor pins 111 at a lower end of the shield case 101. However, it is known from the inventor's examination that, in numerous cases, if a condition such as gap width of not greater than 50 µm and gap length of not greater than 2 mm is maintained, a remarkably strong contact force can be obtained and also a necessary shield property can be achieved.

As a material of the shield case 101, use is made of metal or alloy. In this case, it is effective to use copper or copper alloy having excellent heat radiation property and electrical conductivity. Particularly, it is preferred to use brass, phosphorus bronze, nickel copper, titanium copper, Corson alloy or beryllium copper, which have an excellent spring property and do not show a permanent deformation.

### Example 1

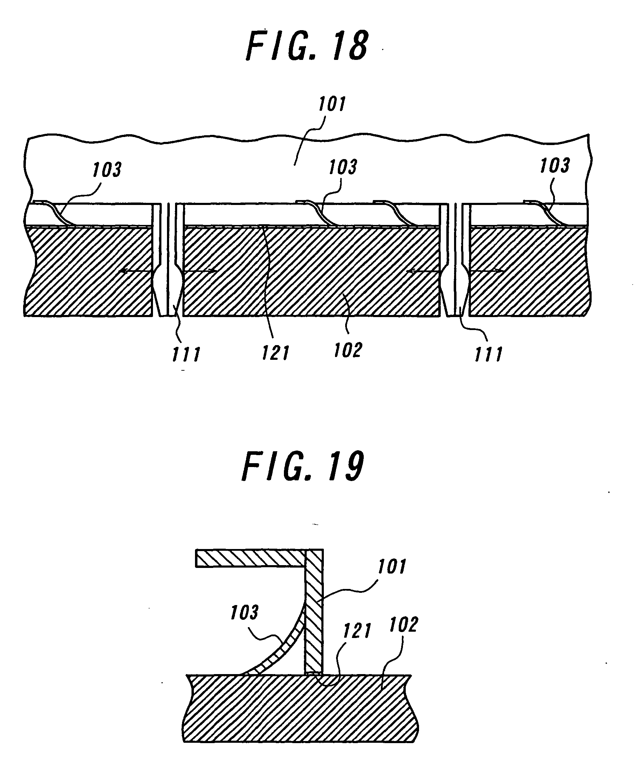

In the example 1, as shown in Fig. 18, thin plate springs 103 made of metal are arranged between a lower end of the shield case 101 and the ground wire 121.

The thin plate spring 103 mentioned above presses both of the lower end of the shield case 101 and the ground wire 121, and functions to compensate an electrical contact between them.

Instead of a straight shape of the thin plate spring 103 as shown in Fig. 18, use may be made of a folding shape or a curved shape.
But, in the case that it is necessary to minimize the gap between the lower end of the shield case 101 and the ground wire 121, it is preferred to use the thin plate spring 103 having the straight shape as shown in Fig. 18 as compared with the other folding shape or curved shape.

The thin plate spring 103 presses the shield case 101 toward an upper side i.e. in a direction departing from the circuit board 102. Therefore, among the examples shown in Figs. 21A, 21B, 22A and 22B, in the case that the anchor pin 111 is protruded from the through hole 122 at the rear side of the circuit boards 102 and further protruded toward the side portion as shown in Figs. 21B and 22B, since a force pressing the protruded portion upward by the thin plate spring 103 can be prevented, it is a preferred example.

On the other hand, in the case that the example 1 is applied to the designs shown in Figs. 21A and 22A, it is necessary to consider a balance between an upwardly pressing force of the thin plate spring 103 and a friction force generated when the side portion of the anchor pin 111 presses the side portion of the through hole 122.

In the example 1, since the thin plate springs 103 are assembled, a gap between the shield case 101 and the ground wire 121 is necessarily increased. Therefore, whether the thin plate springs 103 are assembled as shown in the example 1 or not is appropriately determined in consideration of a level of the gap formed due to the thin plate springs 103, levels of frequency and amplitude of the electromagnetic wave generated in the shield case 101, a size level of the shield case 101, and a level of affection due to the electromagnetic wave with respect to the circuit parts in the shield case 101.

In this example, it is preferred from the viewpoint of working efficiency to form the thin plate springs 103 and the shield case 101 integrally.

### Example 2

In the example 2, as shown in Fig. 19, the thin plate spring 103 made of metal is formed from the side portion of the shield case 101 in an oblique and downward direction in such a manner that the thin plate spring 103 presses an upper surface of the circuit board 102.

In Fig. 19, the thin plate spring 103 is projected inwardly in the shield case 101, but it may be projected outwardly from an outer surface of the side portion of the shield case 101 (if taking into consideration of handling operation, it is better to project the thin plate spring inwardly in the shield case).

In the example 2, the shield case 101 and the thin plate spring 103 are not formed integrally. However, since the thin plate spring 103 is not arranged between the side portion of the shield case 101 and the ground wire 121, the gap formed between them can be further minimized as compared with the example 1.

As is the same as the example 1, it is preferred from the viewpoint of working efficiency to form the thin plate spring 103 of the example 2 and the shield case 101 integrally.

Since the thin plate spring 103 of the example 2 presses the circuit board 102, a gap between the thin plate spring and the circuit board 102 is hardly existent.

In the case that the thin plate spring 103 is made of metal, the thin plate spring 103 itself exhibits a shield function.

Therefore, it is possible to improve sufficiently a shield effect by means of the thin plate spring 103, if the ground wire 121 made of metal is arranged also at a portion of the circuit board 102 to which the thin plate spring 103 presses, and further, if the thin plate springs 103 are formed to the inner side and the outer side of the shield case 101 alternately and the alternately formed thin plate springs 103 surround an overall side portion of the shield case 101 from one of the inner side and the outer side.

In the following, embodiments according to the present invention are described.

### Embodiment 1

In the embodiment 1, as shown in Fig. 20, a conductive paste material 104 is arranged to a lower end of the shield case 101.

In the case that the conductive paste material 104 mentioned above is arranged, the lower end of the shield case 101 and the ground wire 121 of the circuit board 102 are necessarily filled with the conductive paste material 104, and thus there is no gap between them, so that a shield effect of the electromagnetic wave can be exerted sufficiently.

Therefore, the embodiment 1 is preferably used in the case that wavelength of the electromagnetic wave is small, in the case that amplitude of the electromagnetic wave is large, or in the case that a volume of the shield case 101 is small.

In this manner, in the setting construction of the shield case on the circuit board according to the invention, the shield effect of the electromagnetic wave generated from the electric parts can be achieved by a simple construction such that the anchor pin is projected from the lower end of the shield case and is inserted into the through hole of the circuit board. In addition, it is possible to eliminate the drawbacks mentioned in the above ① - ⑤ sections due to the brazing.

Further, it is possible to eliminate ventilation holes by using copper or copper alloy having excellent heat radiation property and electric conductivity as the shield case. On the other hand, as shown in the embodiment 1, it is possible to design the construction such that a leakage of the electromagnetic wave via the gap between the shield case and the circuit board can be sufficiently eliminated.

The setting construction of the shield case on the circuit board with an outer casing according to the invention comprises the construction such that, a plurality of lock pins formed integrally with the shield case are inserted into the through holes arranged to an upper portion of the outer casing, and, a side portion of the lock pin presses elastically a side portion of the through hole with each other, so that the shield case and the outer casing are firmly connected. In this embodiment, the lock pin constitutes the bending elastic pin.
On the other hand, since the circuit board and the outer casing are previously formed integrally, the shield case and the circuit board are connected indirectly via the connection mentioned above. This is the basic feature of this embodiment.

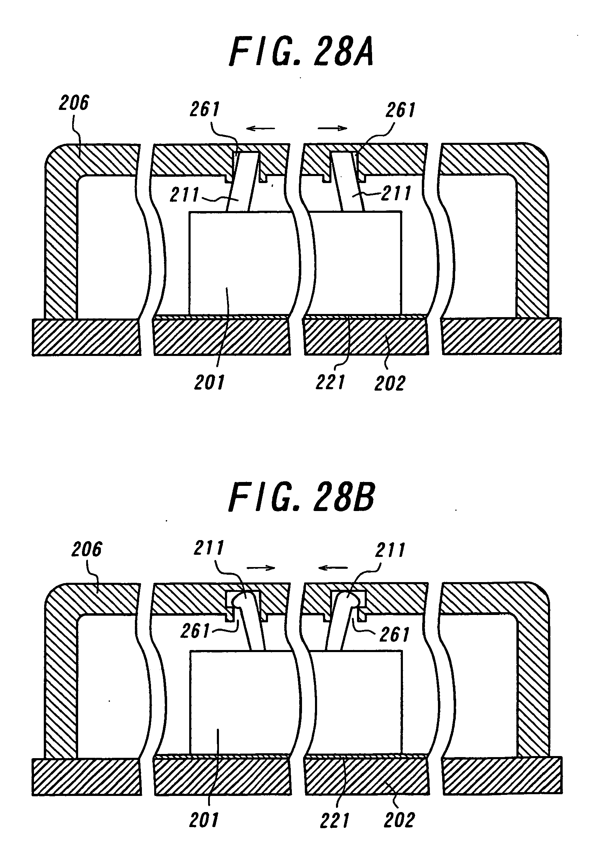

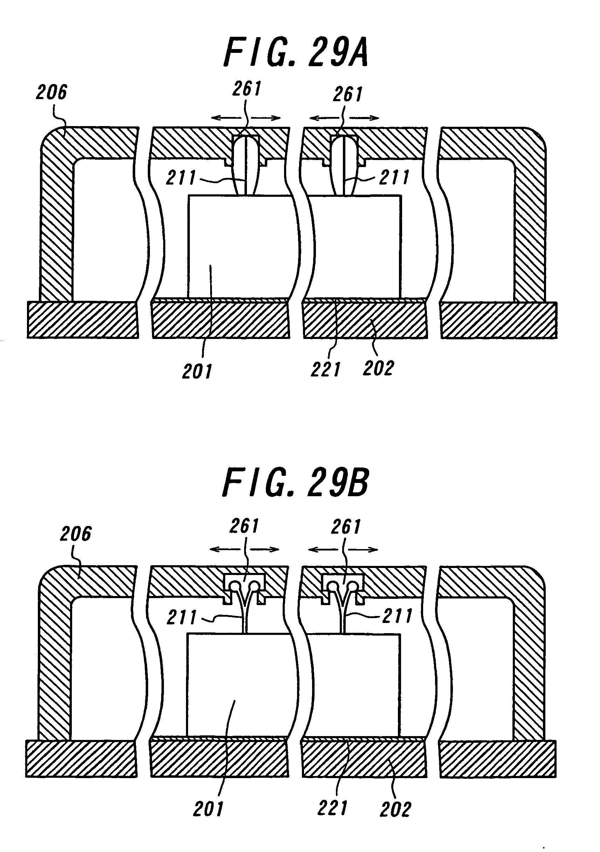

In order to achieve the setting connection mentioned above, as shown in Figs. 28A and 28B, an interval between lock pins 211 having a bending elastic property and an interval between holes 261 on a circuit board 202 are not same but slightly deviated. Therefore, it is possible to take one construction such that the lock pin 211 inserted into the hole 261 is elastically deformed in right direction or left direction so that the side portion of the lock pin 211 presses the side portion of the hole 261, or, another construction such that, as shown in Figs. 29A and 29B, the lock pin 211 having a bending elastic property is divided into plural pieces in a longitudinal direction and, in a normal state, a diameter of the lock pin 211 is designed to be slightly larger than that of the hole 261, so that the side portion of the lock pin 211 presses the side portion of the hole 261 when the lock pin 211 is inserted into the hole 261.

Among the embodiments shown in Figs. 28A, 28B, 29A and 29B, in the embodiments shown in Figs. 28A and 29A, a diameter in a cross section of the through hole 261 is constant, and, in the embodiments shown in Figs. 28B and 29B, a diameter in a cross section of the through hole 261 is designed to be a two step construction wherein a diameter at the upper side is larger than that of the lower side, and an upper portion of the lock pin 211 presses elastically an upper portion of the through hole 261.

In the embodiments shown in Figs. 28B and 29B, since the upper portion of the lock pin 211 is protruded in a direction of the side portion with respect to the lower portion of the through hole 261, it is possible to achieve more firmly connection between the shield case 201 and the outer casing 206.

In the embodiments shown in Figs. 28A, 28B, 29A and 29B, the lock pin 211 is accommodated in the through hole 261, and is not projected outwardly from the outer casing 206. However, it is possible to take a design such that the lock pin 211 is projected outwardly from the outer casing 206 (in the case that the outer casing 206 constitutes an outer surface of product, it is not necessary to take such a design wherein the lock pin is projected).

As the shield case 201, a box type is normally used which are constructed by an upper surface and four side portions opposed with each other, but the shield case 201 is not necessarily limited to such a shape.

That is, for example, it is technically possible to use the shield case 201 having a dome shape such as koh-rakuen baseball stadium.

On the other hand, the metal plate used for the shield case 201 is formed integrally and is worked by a so-called press molding in numerous cases. However, the working method is not necessarily limited to the press molding, and, for example, it is possible to take a design such that a thin metal plate covers - a skeleton having a truss structure.

In the present invention, the connection using the braze (known technique) is not used by performing the connection such that the lock pin 211 is inserted into the through hole 261 of the outer casing 206. Therefore, the drawbacks mentioned previously in the ① - ⑤ sections can be cleared.

Since the connection using the brazing is not used, a slight gap (space) is necessarily generated between a lower end of the shield case 201 and the ground wire 221 of the circuit board 202.

However, in the present invention, at least a part of the shield case 201 and the ground wire 221 of the circuit board 202 are electrically connected. In this case, since the shield case 201 and the ground wire 221 have substantially same potential, it is possible to take a design such that a leakage of electric field at the gap can be decreased. Moreover, since the integrality of the connection can be minimized more and more, it is possible to take a design such that a leakage of electromagnetic wave can be decreased.

The electrical connection mentioned above can be achieved by connecting directly at least a part of the lower end of the shield case 201 or by connecting them indirectly via a conductive member such as metal.

Even if the slight electromagnetic wave is leaked outward via the gap, the external circuits are not necessarily affected.

That is, a level of the leaked electromagnetic wave corresponds to a level of the gap, levels of wavelength and amplitude of the electromagnetic wave, and a size of the shield case 201. However, it is known from various tests that affection for the external circuit parts due to the leaked electromagnetic wave can be prevented by taking a design such that the gap between the connection between the shield case 201 and the circuit board 102 is minimized.

Moreover, since semiconductors such as power amplifier for a high frequency circuit are assembled in the shield case 201, the electric parts in the shield case 201 generate heat.

In order to prevent a deterioration of the electric parts itself due to such a heat, a plurality of small holes are sometimes formed to the shield case 201.

Moreover, in order to prevent a leakage of electromagnetic wave from these plural small holes, it is necessary to make a diameter of each small holes fine ( a fine level of the diameter corresponds to levels of wavelength and amplitude of the electromagnetic wave). However, if a diameter design is too fine, a ventilation property of the shield case 201 is decreased and a heat prevention property is extremely insufficient. In addition, a leakage of electromagnetic wave from the small holes is remarkably increased sometimes.

In the present invention, as mentioned above, the connection between a lower end of the shield case 201 and the ground wire 221 is sufficiently made closer. In addition, use is made of high heat-conductive spring copper or copper alloy as the shield case 201. Therefore, it is possible to take a design such that no small holes for heat radiation are arranged.

A contact level between the shield case 201 and the circuit board 202 i.e. a level of the gap corresponds to an interval between the lock pins 211 at a lower end of the shield case 201. However, it is known from the inventor's examination that, in numerous cases, if a condition such as gap width of not greater than 50 µm and gap length of not greater than 2 mm is maintained, a remarkably strong contact force can be obtained and also a necessary shield property can be achieved.

As a material of the shield case 201 according to the invention, use is made of metal or alloy. In this case, it is effective to use copper or copper alloy having excellent heat radiation property and electrical conductivity. Particularly, it is preferred to use brass, phosphorus bronze, nickel copper, titanium copper, Corson alloy or beryllium copper, which have an excellent spring property and do not show a permanent deformation.

### Embodiment 2

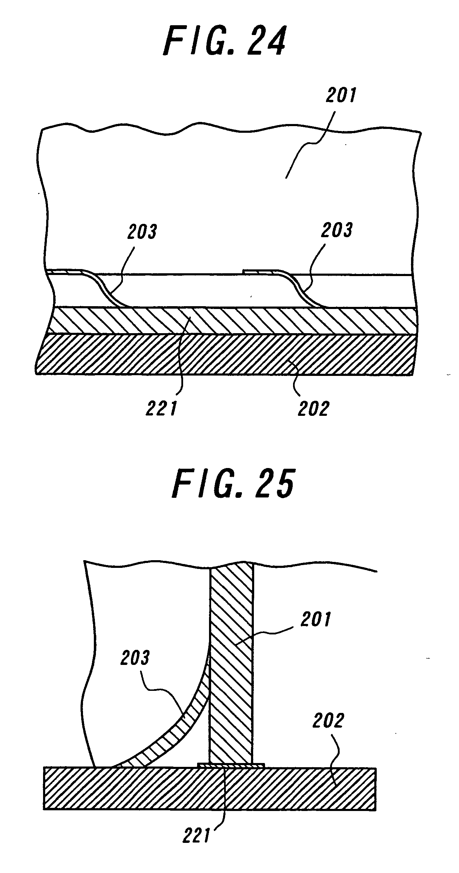

In the embodiment 2, as shown in Fig. 24, thin plate springs 203 made of metal are arranged between a lower end of the shield case 201 and the ground wire 221.

The metal thin plate spring 203 mentioned above presses both of the lower end of the shield case 201 and the ground wire 221, and functions to compensate an electrical contact between them.

Instead of a straight shape of the metal thin plate spring 203 as shown in Fig. 24, use may be made of a folding shape or a curved shape.
But, in the case that it is necessary to minimize the gap between the lower end of the shield case 201 and the ground wire 221, it is preferred to use the metal thin plate spring 203 having the straight shape as shown in Fig. 24 as compared with the other folding shape or curved shape.

The metal thin plate spring 203 presses the shield case 201 toward a side of the outer casing 206, it is possible to connect the outer casing 206 and the shield case 201 more and more firmly.

In the embodiment 2, since the metal thin plate springs 203 are assembled, a gap between the shield case 201 and the ground wire 221 is necessarily increased. Therefore, whether the metal thin plate springs 203 are assembled as shown in the embodiment 2 or not is appropriately determined in consideration of a level of the gap formed due to the metal thin plate springs 203, levels of frequency and amplitude of the electromagnetic wave generated in the shield case 201, a size level of the shield case 201, and a level of affection due to the electromagnetic wave with respect to the circuit parts in the shield case 201.

In this embodiment, it is preferred from the viewpoint of working efficiency to form the metal thin plate springs 203 and the shield case 201 integrally.

### Embodiment 3

In the embodiment 3, as shown in Fig. 25, the thin plate spring 203 made of metal is formed from the side portion of the shield case 201 in an oblique and downward direction in such a manner that the metal thin plate spring 203 presses an upper surface of the circuit board 202.

In Fig. 25, the metal thin plate spring 203 is projected inwardly in the shield case 201, but it may be projected outwardly from an outer surface of the side portion of the shield case 201 (if taking into consideration of handling operation, it is better to project the thin plate spring inwardly in the shield case).

In the embodiment 3, the shield case 201 and the metal thin plate spring 203 are not formed integrally. However, since the metal thin plate spring 203 is not arranged between the side portion of the shield case 201 and the ground wire 221, the gap formed between them can be further minimized as compared with the embodiment 2.

As is the same as the embodiment 2, it is preferred from the viewpoint of working efficiency to form the metal thin plate spring 203 of the embodiment 3 and the shield case 201 integrally.

Since the metal thin plate spring 203 of the embodiment 3 presses the circuit board 202, a gap between the metal thin plate spring and the circuit board 202 is hardly existent.

In the case that the thin plate spring 203 is made of metal, the thin plate spring 203 itself exhibits a shield function.

Therefore, it is possible to improve sufficiently a shield effect by means of the metal thin plate spring 203, if the ground wire 221 made of metal is arranged also at a portion of the circuit board 202 to which the metal thin plate spring 203 presses, and further, if the thin plate springs 203 are formed to the inner side and the outer side of the shield case 201 alternately and the alternately formed metal thin plate springs 203 surround an overall side portion of the shield case 201 from one of the inner side and the outer side.

### Embodiment 4

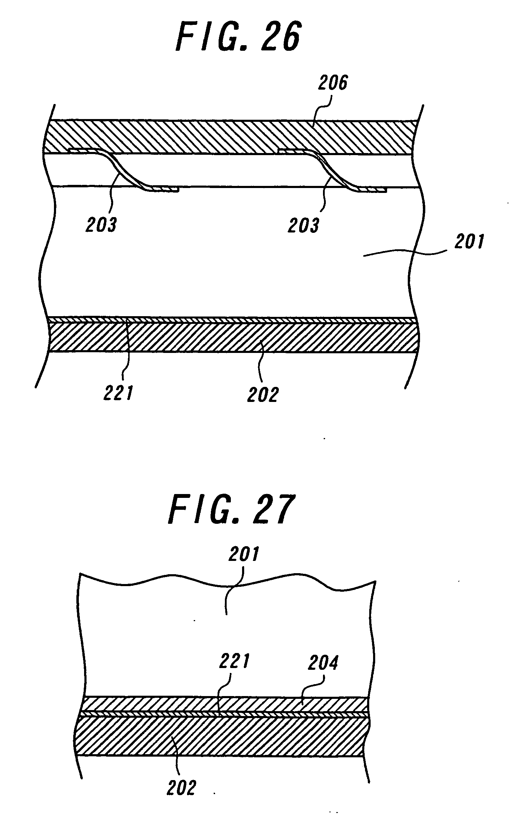

In the embodiment 4, as shown in Fig. 26, the metal thin plate springs 203, which function to press both of the shield case 201 and the outer casing 206, are arranged between an upper side of the shield case 201 and the outer casing 206.

Since the metal thin plate spring 203 presses the shield case 201 toward a side of the circuit board 202, a gap between them can be decreased and a shield effect can be improved.

In this case, since the metal thin plate spring 203 of the embodiment 4 function s to press both of the shield case 201 and the outer casing 206, it is possible to prevent the function of the metal thin plate spring 203 mentioned above in the embodiments shown in Figs. 28B and 29B wherein a diameter of the upper portion of the lock pin 211 is protruded with respect to the lower side of the through hole 261. Therefore, it is a preferred embodiment.

Contrary to this, in the case that the embodiment 4 is applied to the designs shown in Figs. 28A and 29A, it is necessary to consider a balance between a pressing force due to the metal thin plate spring 203 and a friction force generated when the side portion of the lock pin 211 presses the side portion of the hole 261.

### Embodiment 5

In the embodiment 7, as shown in Fig. 27, a conductive paste material 204 is arranged to a lower end of the shield case 201.

In the case that the conductive paste material 204 mentioned above is arranged, the lower end of the shield case 201 and the ground wire 221 of the circuit board 202 are necessarily filled with the conductive paste material 204, and thus there is no gap between them, so that a shield effect of the electromagnetic wave can be exerted sufficiently.

Therefore, the embodiment 5 is preferably used in the case that wavelength of the electromagnetic wave is small, in the case that amplitude of the electromagnetic wave is large, or in the case that a volume of the shield case 201 is small.

In this manner, in the setting construction of the shield case on the circuit board with the outer casing according to the invention, the shield effect of the electromagnetic wave generated from the electric parts can be achieved by a simple construction such that, in the circuit board with the outer casing, the lock pin is projected from the upper end of the shield case and is inserted into the through hole of the outer casing. In addition, it is possible to eliminate the drawbacks mentioned in the above ① - ⑤ sections due to the brazing.

Further, it is possible to eliminate ventilation holes by controlling the gap between the under end of the shield case and the ground wire of the circuit board. On the other hand, as shown in the embodiments 3, 4 and 5, it is possible to design the construction such that a leakage of the electromagnetic wave via the gap between the shield case and the circuit board can be sufficiently eliminated.
A setting construction has a construction such that: an elastically deformable pin by a bending stress (hereinafter, called as elastically bending pin) is arranged to a peripheral end of the shield case made of metal or the planar antenna installed in a wireless device; a through hole is arranged to the circuit board or the circuit board and an outer casing; and the shield case or the planar antenna is electrically and/or mechanically connected to the circuit board or the circuit board and the outer casing by inserting the elastically bending pin into the through hole. As a preferred embodiment, the setting construction relates to a setting construction of component parts on the circuit board, a setting construction between a planar antenna installed in a wireless device and the circuit board, a setting construction of a shield case on the circuit board and a setting construction of the shield case on the circuit board with the outer casing.

## Claims

1. A setting construction of a metallic shield case (201) on a circuit board (202), with
elastically deformable pins (211) arranged at the peripheral end of the shield case (201),
**characterized in that**
holes (261) are arranged in an outer casing (206),
the shield case (201) is electrically and/or mechanically connected to the circuit board (202) and the outer casing (206) with the pins (211) inserted into the holes (261),
with said pins being lock pins (211) integral in the upper side of the shield case (201),
each lock pin (211) is inserted into a corresponding one of the holes (261) arranged in the upper portion of the outer casing (206),
a side portion of each lock pin (211) presses elastically against a side portion of the hole (261), and
a ground wire arranged to a portion of the circuit board (202) corresponding to the lower end of the shield case (201) is connected elastically to at least a part of the lower end of the shield case (201).

2. The setting construction of the shield case (201) on the circuit board (202) with the outer casing (206) according to claim 1, wherein a diameter of the hole (261) is designed to be varied in two-step manner such that a diameter at an upper hole is larger than that at a lower hole in a longitudinal direction, and an upper portion of the lock pin (211) is protruded toward a side direction with respect to the lower hole.

3. The setting construction of the shield case (201) on the circuit board (202) with the outer casing (206) according to claim 1, wherein a distance between the lock pins (211) having an elastic property is designed to deviate from a distance between the corresponding holes, so that a side portion of the lock pin (211) presses elastically a side portion of the hole.

4. The setting construction of the shield case (201) on the circuit board (202) with the outer casing (206) according to claim 1, wherein the lock pin (211) is divided into plural pieces in a longitudinal direction, and a diameter of the lock pin (211) is designed to be little larger than that of the hole in a normal state, so that a side portion of the lock pin (211) presses elastically a side portion of the hole.

5. The setting construction of the shield case (201) on the circuit board (202) with the outer casing (206) according to claim 1, wherein small holes for ventilating are not formed to the shield case (201).

6. The setting construction of the shield case (201) on the circuit board (202) with the outer casing (206) according to claim 1, wherein a thin plate spring made of metal for pressing both of the shield case (201) and the circuit board (202) is arranged between the lower end of the shield case (201) and the ground wire.

7. The setting construction of the shield case (201) on the circuit board (202) with the outer casing (206) according to claim 1, wherein a thin plate spring made of metal is arranged in a slant downward direction from a side portion of the shield case (201), and the thin plate spring presses an upper surface of the circuit board (202) by means of an elastic force.

8. The setting construction of the shield case (201) on the circuit board (202) with the outer casing (206) according to claim 7, wherein the ground wire is arranged at a region of the circuit board (202) that is pressed by the thin plate spring.

9. The setting construction of the shield case (201) on the circuit board (202) with the outer casing (206) according to claim 7, wherein the thin plate spring is arranged alternately to an inner side and an outer side of the shield case (201), and an overall surface of the shield case (201) is surrounded by the thin plate spring at one of the inner surface and the outer surface.

10. The setting construction of the shield case (201) on the circuit board (202) with the outer casing (206) according to claim 1, wherein a thin plate spring made of metal for pressing both of the shield case (201) and the outer casing (206) is arranged between an upper end of the shield case (201) and the outer casing (206).

11. The setting construction of the shield case (201) on the circuit board (202) with the outer casing (206) according to claim 1, wherein the lower end of the shield case (201) and the ground wire of the circuit board (202) is connected by a conductive paste.

12. The setting construction of the shield case (201) on the circuit board (202) with the outer casing (206) according to claim 1, wherein the shield case (201) is made of brass, phosphorus bronze, nickel copper, titanium copper, Corson alloy or beryllium copper.

## Patentansprüche

1. Befestigungsaufbau eines metallischen Abschirmungsgehäuses (201) an einer Schalttafel (202), mit elastisch verformbaren Stiften (211), die an dem Umfangsende des Abschirmungsgehäuses (201) angeordnet sind, **dadurch gekennzeichnet, dass**
Löcher (261) in einer äußeren Einfassung (206) angeordnet sind,
das Abschirmungsgehäuse (201) elektrisch und/oder mechanisch mit der Schalttafel (202) und der äußeren Einfassung (206) verbunden ist, wobei die Stifte (211) in die Löcher (261) eingefügt sind,
wobei die Stifte Sperrstifte (211) sind, die in der oberen Seite des Abschirmungsgehäuses (201) integriert sind,
wobei jeder Sperrstift (211) in ein entsprechendes Loch von den Löchern (261) eingefügt ist, die in dem oberen Abschnitt der äußeren Einfassung (206) angeordnet sind,
ein Seitenabschnitt von jedem Sperrstift (211) elastisch gegen einen Seitenabschnitt des Loches (261) drückt, und
ein Erdungsdraht, der an einem Abschnitt der Schalttafel (202) entsprechend dem unteren Ende des Abschirmungsgehäuses (201) angeordnet ist, elastisch mit zumindest einem Teil des unteren Endes des Abschirmungsgehäuses (201) verbunden ist.

2. Befestigungsaufbau des Abschirmungsgehäuses (201) an der Schalttafel (202) mit der äußeren Einfassung (206) gemäß Anspruch 1, wobei ein Durchmesser des Loches (261) so ausgelegt ist, dass er sich zweistufig derart ändert, dass ein Durchmesser an einem oberen Loch größer ist als an einem unteren Loch in einer Längsrichtung, und ein oberer Abschnitt des Sperrstiftes (211) zur seitlichen Richtung hinsichtlich des unteren Loches vorsteht.

3. Befestigungsaufbau des Abschirmungsgehäuses (201) an der Schalttafel (202) mit der äußeren Einfassung (206) gemäß Anspruch 1, wobei ein Abstand zwischen den Sperrstiften (211) mit einer elastischen Eigenschaft so ausgelegt ist, dass er von einem Abstand zwischen den entsprechenden Löchern abweicht, so dass ein Seitenabschnitt des Sperrstiftes (211) elastisch einen Seitenabschnitt des Loches drückt.

4. Befestigungsaufbau des Abschirmungsgehäuses (201) an der Schalttafel (202) mit der äußeren Einfassung (206) gemäß Anspruch 1, wobei der Sperrstift (211) in mehreren Stücken in einer Längsrichtung geteilt ist, und ein Durchmesser des Sperrstiftes (211) so ausgelegt ist, dass er ein wenig größer als der Durchmesser des Loches in einem normalen Zustand ist, so dass ein Seitenabschnitt des Sperrstiftes (211) elastisch einen Seitenabschnitt des Loches drückt.

5. Befestigungsaufbau des Abschirmungsgehäuses (201) an der Schalttafel (202) mit der äußeren Einfassung (206) gemäß Anspruch 1, wobei kleine Löcher zur Lüftung nicht an dem Abschirmungsgehäuse (201) ausgebildet sind.

6. Befestigungsaufbau des Abschirmungsgehäuses (201) an der Schalttafel (202) mit der äußeren Einfassung (206) gemäß Anspruch 1, wobei eine dünne Blattfeder aus Metall sowohl zum Drücken des Abschirmungsgehäuses (201) als auch der Schalttafel (202) zwischen dem unteren Ende des Abschirmungsgehäuses (201) und dem Erdungsdraht angeordnet ist.

7. Befestigungsaufbau des Abschirmungsgehäuses (201) an der Schalttafel (202) mit der äußeren Einfassung (206) gemäß Anspruch 1, wobei eine dünne Blattfeder aus Metall in einer nach unten geneigten Richtung von einem Seitenabschnitt des Abschirmungsgehäuses (201) angeordnet ist, und die dünne Blattfeder eine obere Fläche der Schalttafel (202) mittels einer elastischen Kraft drückt.

8. Befestigungsaufbau des Abschirmungsgehäuses (201) an der Schalttafel (202) mit der äußeren Einfassung (206) gemäß Anspruch 7, wobei der Erdungsdraht an einem Bereich der Schalttafel (202) angeordnet ist, der durch die dünne Blattfeder gedrückt wird.

9. Befestigungsaufbau des Abschirmungsgehäuses (201) an der Schalttafel (202) mit der äußeren Einfassung (206) gemäß Anspruch 7, wobei die dünne Blattfeder abwechselnd an einer Innenseite und an einer Außenseite des Abschirmungsgehäuses (201) angeordnet ist, und eine Gesamtfläche des Abschirmungsgehäuses (201) durch die dünne Blattfeder an der inneren Fläche oder der äußeren Fläche umgeben ist.

10. Befestigungsaufbau des Abschirmungsgehäuses (201) an der Schalttafel (202) mit der äußeren Einfassung (206) gemäß Anspruch 1, wobei eine dünne Blattfeder aus Metall sowohl zum Drücken des Abschirmungsgehäuses (201) als auch der äußeren Einfassung (206) zwischen einem oberen Ende des Abschirmungsgehäuses (201) und der äußeren Einfassung (206) angeordnet ist.

11. Befestigungsaufbau des Abschirmungsgehäuses (201) an der Schalttafel (202) mit der äußeren Einfassung (206) gemäß Anspruch 1, wobei das untere Ende des Abschirmungsgehäuses (201) und der Erdungsdraht der Schalttafel (202) durch eine Leitpaste verbunden sind.

12. Befestigungsaufbau des Abschirmungsgehäuses (201) an der Schalttafel (202) mit der äußeren Einfassung (206) gemäß Anspruch 1, wobei das Abschirmungsgehäuse (201) aus Messing, Phosphorbronze, Nickel-Kupfer, Titan-Kupfer, einer Kupferlegierung mit Silizium und Nickel oder aus Beryllium-Kupfer besteht.

## Revendications

1. Construction d'installation d'un boîtier de protection métallique (201) sur une carte de circuit (202), avec
des broches déformables élastiquement (211) agencées à l'extrémité périphérique du boîtier de protection (201), **caractérisée en ce que**
des trous (261) sont agencés dans un boîtier extérieur (206),
le boîtier de protection (201) est connecté électriquement et/ou mécaniquement à la carte de circuit (202) et au boîtier extérieur (206) avec les broches (211) insérées à l'intérieur des trous (261),
avec lesdites broches étant des broches de verrouillage (211) intégrales dans le côté supérieur du boîtier de protection (201),
chaque broche de verrouillage (211) est insérée à l'intérieur de l'un des trous correspondant (261) agencé dans la portion supérieure du boîtier extérieur (206),
une portion latérale de chaque broche de verrouillage (211) appuie élastiquement contre une portion latérale du trou (261), et
un fil de terre agencé à une portion de la carte de circuit (202) correspondant à l'extrémité inférieure du boîtier de protection (201) est connecté élastiquement à au moins une partie de l'extrémité inférieure du boîtier de protection (201).

2. Construction d'installation du boîtier de protection (201) sur la carte de circuit (202) avec le boîtier extérieur (206) selon la revendication 1, où un diamètre du trou (261) est conçu pour être varié d'une manière à deux étapes de sorte qu'un diamètre au niveau d'un trou supérieur soit plus grand que celui au niveau d'un trou inférieur dans une direction longitudinale, et une portion supérieure de la broche de verrouillage (211) est avancée vers une direction latérale par rapport au trou inférieur.

3. Construction d'installation du boîtier de protection (201) sur la carte de circuit (202) avec le boîtier extérieur (206) selon la revendication 1, où une distance entre les broches de verrouillage (211) ayant une propriété élastique est conçue pour dévier d'une distance entre les trous correspondants, de sorte qu'une portion latérale de la broche de verrouillage (211) appuie élastiquement sur une portion latérale du trou.

4. Construction d'installation du boîtier de protection (201) sur la carte de circuit (202) avec le boîtier extérieur (206) selon la revendication 1, où la broche de verrouillage (211) est divisée en plusieurs morceaux dans une direction longitudinale, et un diamètre de la broche de verrouillage (211) est conçu pour être un peu plus grand que celui du trou dans un état normal, de sorte qu'une portion latérale de la broche de verrouillage (211) appuie élastiquement sur une portion latérale du trou.

5. Construction d'installation du boîtier de protection (201) sur la carte de circuit (202) avec le boîtier extérieur (206) selon la revendication 1, où de petits trous pour ventilation ne sont pas formés au boîtier de protection (201)

6. Construction d'installation du boîtier de protection (201) sur la carte de circuit (202) avec le boîtier extérieur (206) selon la revendication 1, où un ressort plat mince fait en métal pour appuyer à la fois sur le boîtier de protection (201) et la carte de circuit (202) est agencé entre l'extrémité inférieure du boîtier de protection (201) et le fil de terre.

7. Construction d'installation du boîtier de protection (201) sur la carte de circuit (202) avec le boîtier extérieur (206) selon la revendication 1, où un ressort plat mince fait en métal est agencé dans une direction descendante en pente depuis une portion latérale du boîtier de protection (201), et le ressort plat mince appuie sur une surface supérieure de la carte de circuit (202) au moyen d'une force élastique.

8. Construction d'installation du boîtier de protection (201) sur la carte de circuit (202) avec le boîtier extérieur (206) selon la revendication 7, où le fil de terre est agencé au niveau d'une région de la carte de circuit (202) qui est pressée par le ressort plat mince.

9. Construction d'installation du boîtier de protection (201) sur la carte de circuit (202) avec le boîtier extérieur (206) selon la revendication 7, où le ressort plat mince est agencé alternativement à un côté intérieur et un côté extérieur du boîtier de protection (201), et une surface d'ensemble du boîtier de protection (201) est entourée par le ressort plat mince au niveau de l'une de la surface intérieure et la surface extérieure.

10. Construction d'installation du boîtier de protection (201) sur la carte de circuit (202) avec le boîtier extérieur (206) selon la revendication 1, où un ressort plat mince fait en métal pour appuyer à la fois sur le boîtier de protection (201) et le boîtier extérieur (206) est agencé entre une extrémité supérieure du boîtier de protection (201) et le boîtier extérieur (206).

11. Construction d'installation du boîtier de protection (201) sur la carte de circuit (202) avec le boîtier extérieur (206) selon la revendication 1, où l'extrémité inférieure du boîtier de protection (201) et le fil de terre de la carte de circuit (202) sont connectés par une pâte conductrice.

12. Construction d'installation du boîtier de protection (201) sur la carte de circuit (202) avec le boîtier extérieur (206) selon la revendication 1, où le boîtier de protection (201) est fait de laiton, de bonze de phosphore, de cupro-nickel, de cupro-titane, d'alliage de Corson ou de cupro-béryllium.
